**Europäisches Patentamt**

**European Patent Office**

**Office européen des brevets**

(11) Numéro de publication: **0 110 794**
**B1**

(12) **FASCICULE DE BREVET EUROPÉEN**

(45) Date de publication du fascicule du brevet:
**19.04.89**

(21) Numéro de dépôt: **83402344.2**

(22) Date de dépôt: **05.12.83**

(51) Int. Cl.⁴: **G 06 F 15/20**

(54) Centrale autonome d'acquisition et de stockage de données.

(30) Priorité: **03.12.82 FR 8220298**

(43) Date de publication de la demande:
**13.06.84 Bulletin 84/24**

(45) Mention de la délivrance du brevet:
**19.04.89 Bulletin 89/16**

(84) Etats contractants désignés:
**AT BE CH DE GB IT LI LU NL SE**

(56) Documents cité:
**GB-A-1 301 292**
**US-A-3 824 590**
**US-A-3 838 445**
**US-A-4 161 782**

(73) Titulaire: **ELECTRICITE DE FRANCE Service National, 2, rue Louis Murat, F-75008 Paris (FR)**

(72) Inventeur: **Boisson, Bernard, 121, rue du Four à Chaux, F-78630 Orgeval (FR)**

(74) Mandataire: **Fort, Jacques, CABINET PLASSERAUD 84, rue d'Amsterdam, F-75009 Paris (FR)**

LIBER, STOCKHOLM 1989

## Description

La présente invention concerne les centrales d'acquisition de données du type comprenant un organe de calcul et de commande associé à un multiplexeur muni de plusieurs entrées analogiques par l'intermédiaire de moyens d'échantillonnage et de conversion analogique/numérique. Dans une telle centrale, le multiplexeur analogique sélectionne une des entrées analogiques à la fois et l'aiguille vers les moyens d'échantillonnage et de conversion. Chaque échantillon numérisé par ces derniers est placé sur le bus de données de l'organe de calcul, qui est souvent prévu pour effectuer un filtrage des données provenant d'une même entrée du multiplexeur, notamment par calcul de la moyenne des valeurs sur une même entrée pendant un intervalle de mesure déterminé. Les valeurs moyennes ainsi obtenues peuvent être fournies par l'organe de calcul à divers types de sorties, par exemple être envoyées à un calculateur central par l'intermédiaire d'un support de télécommunication.

Si on souhaite stocker localement les données ainsi recueillies et traitées pour rendre la centrale autonome, on se heurte fréquemment au problème du stockage des données; même si l'on effectue un filtrage par calcul de moyenne, le volume des données à stocker oblige à prévoir une taille de mémoire incompatible avec la constitution d'une centrale portative. Le document U.S.A. 4 161 782 décrit notamment une centrale d'acquisition et de stockage de données du type décrit dans le préambule de la revendication 1 et nécessitant un volume de mémoire important.

L'invention vise à fournir une centrale d'acquisition et de stockage de données qui tout à la fois est autonome, c'est-à-dire est susceptible de fonctionner sans être reliée à un système informatique et présente un volume de mémoire réduit pour une quantité déterminée de données à mémoriser.

Dans ce but, l'invention propose notamment une centrale d'acquisition et de stockage conforme à la revendication 1.

L'invention trouve une application particulièrement importante, bien que non exclusive, constituée par les centrales de mesure, dans lesquelles les entrées analogiques sont reliées à des capteurs. En effet, il est fréquent que les informations fournies par ces capteurs varient peu sur de longs intervalles de temps. Il est alors superflu de stocker en mémoire des valeurs répétitives.

La mémoire est avantageusement du type à bulles magnétiques qui présente les avantages d'un temps d'accès beaucoup plus court que les disques souples et surtout que les bandes magnétiques et d'un encombrement moindre. L'organe de calcul comportera en règle générale un microprocesseur muni de mémoires de travail à lecture/écriture, ou RAM, et de mémoires mortes, éventuellement réprogrammables, contenant le programme. Ces mémoires sont avantageusement réalisées en technologie C-MOS pour réduire la consommation et permettre d'alimenter soit normalement, soit seulement en cas de défaillance d'un réseau d'alimentation, les circuits à l'aide d'une batterie locale. Cette batterie permettra également de sauvegarder le contenu de la mémoire de travail par transfert dans la mémoire à bulles magnétiques en cas de coupure de l'alimentation principale et avant qu'elle ne soit épuisée.

L'invention sera mieux comprise à la lecture de la description qui suit d'un mode particulier d'exécution donné à titre d'exemple non limitatif. La description se réfère au dessin qui l'accompagne, dans lequel:
- la figure 1 est un synoptique de principe d'une centrale de mesure mettant en oeuvre l'invention;
- la figure 2 est un schéma montrant la structure d'un mot de données destiné à être inscrit en mémoire de masse;
- la figure 3 est un organigramme du processus de compression.

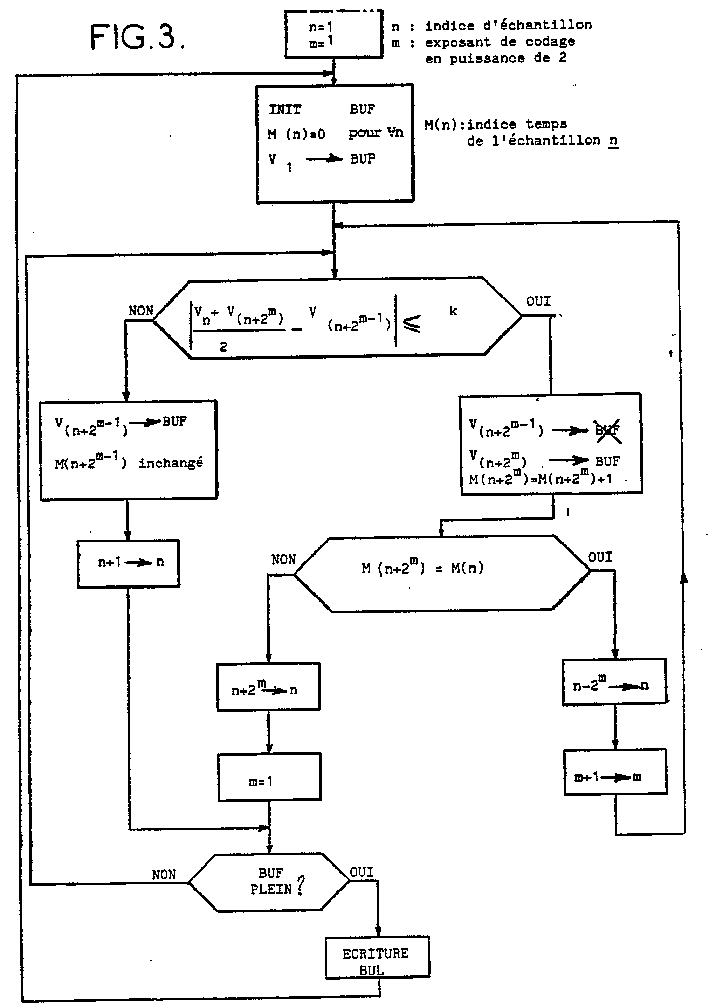

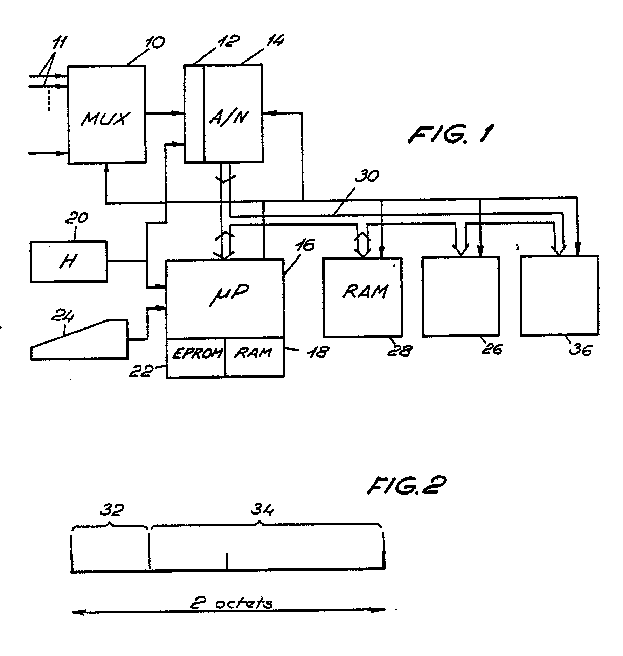

La centrale de mesure montrée schématiquement en figure 1 comporte un multiplexeur analogique 10 muni de n entrées 11 (n étant in nombre entier supérieur à 1, qu'on supposera par la suite égal à 8). Ces entrées peuvent être reliées chacune à un capteur non représenté. Les capteurs peuvent être de nature très diverse, la seule condition requise étant que le capteur fournisse un signal de sortie électrique qui, éventuellement après mise en forme, a une polarité, une valeur maximale et une dynamique compatibles avec la partie analogique de la centrale de mesure.

La sortie du multiplexeur 10 est reliée à des moyens d'échantillonnage et de numérisation qui peuvent être constitués par un échantillonneur-bloqueur 12 et un convertisseur analogique 14, commandés par l'unité de traitement d'un organe de calcul, unité qui sera généralement un microprocesseur 16. L'utilisation d'un seul convertisseur, qui constitue un composant coûteux, permet de réduire sensiblement le prix global de la centrale.

Le microprocesseur 16 est associé à une horloge 20, qui constitue également la base de temps pour le convertisseur 14, à une mémoire de travail 18 à lecture/écriture et à une mémoire morte reprogrammable 22, généralement du type EPROM ou REPROM. L'organe de calcul comportera généralement encore un pupitre d'entrée 24, permettant notamment d'effectuer des tests de bon fonctionnement avant mise en service et de sélectionner divers paramètres de fonctionnement.

On sait qu'avec un échantillonnage à fréquence donnée, on peut obtenir une bande passante dont la limite haute correspond à la moitié de cette fréquence. On obtiendra donc une bande passante allant de 0 à 2 Hz si l'échantillonnage s'effectue sur chaque entrée à la cadence de quatre échantillons par seconde. Dans le cas ci- dessus envisagé d'un multiplexeur à huit entrées 11, les organes 12 et 14 devront échantillonner et numériser trente-deux valeurs par seconde, ce qui est facile à obtenir même avec un convertisseur A/N 14 de précision élevée, par exemple du genre intégrateur à double pente. Toujours dans le cas de huit entrées, la scrutation des capteurs peut s'effectuer par adressage du multiplexeur sur trois bits seulement à partir du microprocesseur 16. Lorsque ce dernier est du type à mots de seize bits (c'est-à-dire deux octets), le convertisseur analogique/numérique 14 peut notamment être prévu pour coder les valeurs sur dix bits, ce qui correspond à 1023 niveaux de quantification.

Un programme stocké en mémoire morte 22 du microprocesseur 16 permet d'effectuer des calculs de moyennes sur les données en provenance de chaque entrée 11. Pour cela, la mémoire de travail 18 comporte des zones réservées pour constituer des tampons de mémoire de capacité suffisante. Le programme du microprocesseur peut prévoir le calcul de la façon suivante:

- cumul du total des mesures effectuées sur chaque entrée 11 pendant un intervalle de temps déterminé de prise d'informations, (intervalle qui sera avantageusement sélectionnable à l'aide du pupitre 24),

- comptage du nombre de mesures cumulées,

- établissement de la moyenne des résultats de la mesure pendant un intervalle de temps de prise d'informations.

La moyenne pourra être définie avec une précision supérieure à celle du codage des mesures individuelles, par exemple sur douze bits dans le cas mentionné plus haut.

Un programme également enregistré en mémoire morte 22 du microprocesseur 16 permet de soumettre les moyennes ainsi calculées à un processus de compression qui est essentiel pour réduire la taille de la mémoire de masse 26 nécessaire pour stocker les données. Divers processus de compression, permettant de ne retenir que des valeurs significatives, peuvent être utilisés. Dans tous les cas, ce processus rendra nécessaire de prévoir une mémoire tampon de compression 28 reliée, comme la mémoire de masse 28, au bus de données 30 de l'organe de calcul. Les moyennes calculées sont introduites dans cette mémoire tampon 28 pour constituer des piles.

Parmi les processus de compression qui peuvent être utilisés, on utilisera avantageusement la compression dichotomique dont le principe est le suivant: lorsqu'on dispose de $\underline{n}$ échantillons consécutifs de valeur $V_n$, séparés par un même intervalle de temps $\underline{t}$, on compare chaque échantillon (échantillon 2) à la demi-somme de deux échantillons qui l'encadrent (échantillons 1 et 3). Si la différence est inférieure à une tolérance $\pm$ k que l'on se fixe au départ, généralement égale à un bit du convertisseur, c'est-à-dire si les valeurs $V_1$, $V_2$ et $V_3$ remplissent la condition

$$\left| \frac{V_1 + V_3}{2} - V_2 \right| \leqslant k,$$

$V_2$ est éliminé. A la reconstitution, on interpole sa valeur par $\frac{V_1 + V_3}{2}$. On associe à $V_3$ le temps qui le sépare de $V_1$ par codage de la puissance de 2 du nombre d'intervalles $\underline{t}$. La compression dichotomique ne compare donc que des échantillons équidistants de $2^m t$: en codant $\underline{m}$, on peut réduire l'encombrement mémoire de cette information temporelle.

Dans le cas contraire, $V_1$ et $V_2$ sont conservés. On compare comme précédemment $V_3$, $V_4$ et $V_5$ et ainsi de suite éventuellement.

Si l'on avait éliminé $V_2$ et que $V_4$ réponde également au critère de compression, on comparerait alors $V_3$ à la demi-somme $V_1 + V_5$ distants cette fois de 4 t. On cherche ensuite à comparer éventuellement des échantillons distants de 8t, 16t, etc. par rapport à l'échantillon central qui subsiste seul: l'organigramme correspondant est donné en figure 3.

Dans le cas envisagé plus haut d'un microprocesseur utilisant des mots de deux octets, on peut prévoir de limiter l'exposant $\underline{m}$ à une valeur de 14 (en décimal) pour tenir compte de considérations de volume en mémoire. L'écart maximum est alors de 16384 fois la période de prise d'information sur une même entrée. Chacune des données à ranger en mémoire de masse 26 pourra alors être constituée par un mot de seize bits, dont les quatre premiers sont représentatifs d'un intervalle de temps, les douze suivants de la valeur moyenne. Il faut remarquer au passage que, tant que la résolution recherchée reste comprise entre 9 et 12 bits, c'est-à-dire nécessite plus d'un octet et laisse quatre bits disponibles pour définir l'intervalle de temps, la compression n'utilise que des bits surabondants qui resteraient inutilisés sans elle. La structure d'un mot est alors celle représentée en figure 2. La partie 32 identifie l'intervalle de temps, la partie 34 la valeur à mémoriser.

La mémoire de masse 26 est avantageusement constituée par une cassette de mémoire à bulles, disponible à l'heure actuelle avec une capacité de 1 Megabit, permettant d'enregistrer 8192 mesures par voie d'entrée pour chacune de ces entrées. A la cadence d'une moyenne effectuée toutes les cinq minutes pour chaque voie, l'autonomie de la centrale est alors de vingt-huit jours. Elle est nettement augmentée par la compression et, au surplus, si certaines voies d'entrée ne sont pas utilisées. On ne décrira pas ici l'ensemble constitué par la cassette de mémoire à bulles et par l'ensemble associé, car il peut être constitué de façon entièrement classique. On peut notamment utiliser un ensemble comportant une cassette à bulles magnétiques de 1 Mbits associé à l'unité d'affichage FBM-U 001 et à la carte de commande FBC 308CIA de FUJITSU ou le kit INTEL BPK72 conditionné en cassette à bulle.

Le logiciel du microprocesseur 16 est de préférence prévu pour enregistrer les données en mémoire en "mode page", c'est-à-dire pour n'alimenter la carte de commande de la mémoire que lorsque, pour une entrée analogique particulière, une page constituée par un nombre prédéterminé (par exemple soixante-quatre) d'octets de données compressées a été préparée.

Des octets supplémentaires d'identification sont prévus pour préciser le numéro de la voie concernée, codé sur quatre bits, et le numéro d'instant de l'enregistrement modulo 4096. Douze bits sont réservés au numéro de l'instant d'enregistrement, les bits de poids fort de ce numéro étant perdus, tandis que les quatre autres bits donnent le numéro de la voie d'entrée concernée par la page.

La centrale de mesure comportera généralement un dispositif d'affichage 36. Ce dispositif sera par exemple prévu pour visualiser six caractères, deux pour indiquer un numéro de voie d'entrée, quatre pour indiquer la valeur d'une mesure. Le dispositif de visualisation peut être combiné au pupitre 24 et porter divers commutateurs de choix de paramètres, par exemple un commutateur de choix de la période de prise d'informations et un commutateur de choix du mode de visualisation des mesures.

La centrale est complétée par divers dispositifs de sauvegarde, par exemple pour vider le contenu des mémoires tampons de compression 28 dans la cassette mémoire 26 avant autorisation d'enlèvement de cette dernière.

La centrale comporte une alimentation locale, constituée par une batterie d'accumulateur (non représentée) qui peut être prévue soit comme source normale de fonctionnement, soit comme source de secours, en cas de panne de l'alimentation normale. Dans les deux cas, un circuit de détection est prévu pour fournir une alarme lorsque la source d'énergie locale est presque épuisée. Cette alarme est transmise au microprocesseur 16, dont le logiciel comporte un programme de sauvegarde qui transfert en mémoire à bulles, non volatile, toutes les mesures présentes en mémoire vive et en mémoire tampon et coupe automatiquement le fonctionnement de l'installation.

L'ensemble de la centrale peut être constitué en composants actuellement disponibles sur le marché, en faisant le plus largement possible appel aux composants C-MOS. L'utilisation de tels circuits et d'une mémoire à cassette à bulles (dont la cassette et les circuits d'interface ne sont sous tension que pendant la durée d'un enregistrement ou d'une lecture) permet de réduire la consommation à un point tel qu'un fonctionnement sur source locale est possible. Le microprocesseur 16 peut notamment être le modèle MCM 146 805 E2 de MOTOROLA, équipé d'une mémoire morte EPROM 27C 16, de réception du logiciel résident.

La centrale est avantageusement munie d'un dispositif de test de haut niveau afin qu'elle présente un degré de fiabilité élevé au moment de la mise en service comme au relevé des enregistrements. Ce dispositif met en oeuvre le microprocesseur 16 et utilise des programmes assurant les fonctions suivantes:

Test des mémoires EPROM 22, RAM 18 et 28, et écriture-lecture préalable de la cassette à bulle 26.

Tests périodiques des entrées analogiques 11 par substitution des capteurs, en gain et dérive de zéro avec recalibration dans des limites acceptables fixées.

Test des alimentations.

Tests de lecture après écriture de la mémoire à bulle 26 et, si après trois tentatives une erreur persiste, l'adresse de la page, le nombre et l'état du type de défaut décelé par le contrôleur sont visualisés au pupitre 24 et inscrits dans la mémoire à bulle.

Des pages seront réservées à ces diagnostics de test intéressant des fractions de mémoire.

L'invention ne se limite évidemment pas aux modes particuliers de réalisation qui ont été représentés et décrits à titre d'exemples et il doit être entendu que la portée du présent brevet s'étend à toute variante restant dans le cadre des équivalences.

**Revendications**

1. Centrale d'acquisition et de stockage de données comprenant un organe de calcul et de commandes associé à un multiplexeur (10) muni de plusieurs entrées analogiques par l'intermédiaire de moyens d'échantillonnage et de conversion analogique/numérique (12, 14) transformant les données analogiques en une suite d'échantillons séparés par un même intervalle de temps prédéterminé, comportant une mémoire de masse non volatile (26) et des moyens (28) de compression des données par omission des informations redondantes avant écriture en mémoire de masse (26), caractérisée en ce que les moyens de compression sont réalisés pour effectuer la compression des échantillons en comparant la valeur absolue de la différence entre un échantillon médian et la demi-somme des deux échantillons antérieur et postérieur qui l'encadrent d'une même distance temporelle composée d'un nombre entier d'intervalles de temps $t$ à une valeur déterminée $k$, chaque échantillon étant affecté d'une étiquette ou indice temps représentant un nombre d'intervalles de temps et,

lorsque ladite valeur absolue est inférieure ou égale à $k$ en éliminant comme redondant l'échantillon médian et en stockant l'échantillon postérieur avec un indice temps représentatif du nombre d'intervalles de temps séparant l'échantillon antérieur dudit échantillon postérieur stocké,

lorsque ladite valeur absolue est supérieure à $k$ en stockant l'échantillon médian avec un indice temps représentatif du nombre d'intervalles de temps séparant l'échantillon antérieur dudit échantillon médian stocké,

et en ce que les échantillons stockés et leurs indices temps le sont sous la forme de nombres binaires indiquant la valeur de l'échantillon (34) et l'indice temps qui lui est associé (32).

2. Centrale suivant la revendication 1, caractérisée en ce que l'organe de calcul est prévu pour effectuer la moyenne des valeurs prises par les données en provenance de chaque entrée pendant un intervalle de mesure déterminé, la compression étant effectuée sur les moyennes.

3. Centrale suivant la revendication 1 ou 2, caractérisée en ce que la mémoire non volatile (26) est constituée par une cassette de mémoires à bulles magnétiques.

4. Centrale suivant l'une quelconque des revendications précédentes, caractérisée en ce que la mémoire de masse (26) est organisée par pages affectées chacune à l'une des entrées et en ce que la centrale comporte une mémoire tampon (28) de compression dans laquelle les moyens calculées sont introduites pour constituer des piles, l'organe de calcul étant prévu pour transférer les données compressées correspondant à une entrée (11) par page compléte dans la mémoire de masse (26).

5. Centrale suivant la revendication 4, caractérisée en ce que les calculs sont effectués sur seize bits, en ce que l'organe de calcul est prévu pour affecter à chaque page de données un mot de seize bits d'identification dont quatre bits identifient l'entrée correspondant à la page et les douze bits restants définissent le numéro de l'instant d'enregistrement modulo 4096.

6. Centrale suivant l'une quelconque des revendications précédentes, caractérisée en ce qu'elle comporte une source locale d'énergie électrique et en ce que le logiciel de l'organe de calcul est prévu pour transférer en mémoire de masse non volatile (26) le contenu des mémoires vives à lecture/écriture de la centrale en réponse à une détection d'épuisement de la source d'énergie locale.

**Patentansprüche**

1. Autonome Zentrale zur Datenerfassung und Speicherung, mit einer Rechen- und Steuereinheit, die über Einrichtungen zur Probenahme und Analog/Digital-Umwandlung (12, 14) mit einem Multiplexer (10) verbunden ist, welcher eine Mehrzahl von Analogeingängen aufweist, wobei die Einrichtung zur Digital/Analog-Umwandlung die analogen Daten in eine Folge von Proben, welche voneinander durch dasselbe vorbestimmte Zeitintervall t getrennt sind, umwandelt, einem nicht flüchtigen Massenspeicher (26), und Einrichtungen (28) zur Komprimierung der Daten durch Weglassung von redundanten Informationen vor dem Einschreiben in den Massenspeicher (26), dadurch gekennzeichnet, daß die

Komprimierungseinrichtungen (26) die Komprimierung der Proben so ausführen, daß sie den Absolutwert der Differenz zwischen einer mittleren Probe und der Halbsumme zweier dieser Probe mit demselben Zeitabstand vorangehender und nachfolgender Proben vergleichen, wobei der Zeitabstand aus einer ganzen Zahl von Intervallen einer Zeit t mit einem festgelegten Wert k besteht und jede Probe mit einer Etikette bzw. einem Zeitindex versehen wird, welcher für eine Anzahl von Zeitintervallen repräsentativ ist, wobei dann, wenn der Absolutwert kleiner oder gleich k ist, die mittlere Probe als redundant eliminiert wird und die nachfolgende Probe mit einem Zeitindex gespeichert wird, welcher für die Anzahl der die vorangehende Probe von der gespeicherten nachfolgenden Probe trennenden Zeitintervalle repräsentativ ist, und wobei dann, wenn der Absolutwert größer als k ist, die mittlere Probe mit einem Zeitindex gespeichert wird, welcher für die Anzahl der die vorangehende Probe von der gespeicherten mittleren Probe trennenden Zeitintervalle repräsentativ ist, und daß die gespeicherten Proben und ihre Zeitindices in Form von Binärziffern vorliegen, die den Wert der Probe (34) und den dieser zugeordneten Zeitindex (32) angeben.

2. Zentrale nach Anspruch 1, dadurch gekennzeichnet, daß die Recheneinheit eine Mittelwertsbildung der Werte durchführt, welche die von jedem Eingang kommenden Daten während eines bestimmten Meßintervalls annehmen, wobei die Komprimierung auf die Mittelwerte angewendet wird.

3. Zentrale nach Anspruch 1 oder 2, dadurch gekennzeichnet, daß der nicht flüchtige Speicher (26) aus einer Magnetblasen-Speicherkassette gebildet ist.

4. Zentrale nach einem der vorangegangenen Ansprüche, dadurch gekennzeichnet, daß der Massenspeicher (26) in Seiten organisiert ist, von denen jede einem der Eingänge zugeordnet ist, und daß die Zentrale einem Komprimierungs-Pufferspeicher (28) aufweist, in den die berechneten Mittelwerte zur Bildung von Kolonnen eingeführt werden, wobei die Recheneinheit die komprimierten Daten, welche pro vollständiger Seite einem Eingang (11) entsprechen, in den Massenspeicher (26) überträgt.

5. Zentrale nach Anspruch 4, dadurch gekennzeichnet, daß die Berechnungen auf sechzehn Bits ausgeführt werden, wobei die Recheneinheit jeder Dateseite ein Kennwort aus sechzehn Bits zuordnet, von dem vier Bits den der Seite entsprechenden Eingang und die zwölf übrigen Bits die Nummer des Zeitpunktes der Aufzeichnung Modulo 4096 definieren.

6. Zentrale nach einem der vorangegangenen Ansprüche, dadurch gekennzeichnet, daß sie eine lokale Quelle für elektrische Energie aufweist und daß die Logik der Recheneinheit den Inhalt der Arbeits-Schrieb/Lese-Speicher beim Erfassen einer Erschöpfung der lokalen Energiequelle in den nicht flüchtigen Massenspeicher (26) überträgt.

**Claims**

1. Data recording and storing system comprising a computing and control unit connected to a multiplexer (10) having a plurality of analog signal inputs, via sampling and analog/digital conversion means (12, 14) converting the analog data into a sequence of samples separated from each other by a same predetermined time interval $t$ comprising a non-volatile mass storage memory (26) and means (28) for data compression by omission of redundant data before write-in in the mass memory (26),

characterized in that the compression means are arranged for compressing samples by comparing: the absolute value of the difference between a median sample and the half-sum of a fore-sample and a post-sample which straddle it and are separated from it by a same time period consisting of an integer number of time intervals $t$; and a predetermined-value $k$, each sample being labelled with a label or time indicia representing a number of time intervals; and,

when said absolute value is lower than or equal to $k$, by eliminating, as being redundant, the median sample and by storing the post-sample with a time indicia representative of the number of time intervals separating the fore-sample from said stored post-sample,

when said absolute value is higher than $k$, by storing the median sample with a time indicia representative of the number of time intervals separating the fore-sample from said stored median sample,

and in that the stored samples and their time indicia are stored as binary numbers indicating the value of the sample (34) and the time indicia (32) associated thereto.

2. System according to claim 1,
characterized in that the computing unit is arranged for computing the average of the values assumed by the data from each input during a predetermined time interval, compression being carried out on the average values.

3. System according to claim 1 or 2,
characterized in that the non-volatile memory (26) consists of a magnetic bubble storage cassette.

4. System according to any one of the preceding claims,
characterized in that the mass memory (26) is arranged in pages each assigned to one of the inputs and in that the system further includes a compression buffer memory (28) wherein the computed average values are introduced for constituting stacks, the computing unit being arranged for transferring the compressed data corresponding to one input as a complete page into the mass memory (26).

5. System according to claim 4,
characterized in that the computations are carried out on sixteen bits words, in that the computing unit is arranged for assigning an identification word of sixteen bits, for bits to each data page, four of the bits identifying the input corresponding to the page while the other twelve bits define the serial number of the recordal time, modulo 4096.

6. System according to any one of the preceding claims,
characterized in that it further comprises a local source of electrical energy and in that the hardware of the computing unit is arranged for transferring the contents of the write/read RAMs of the system into the non-volatile mass memory (26) responsive to detection of exhaustion of the local energy source.

FIG.3.

$$n=1$$
$$m=1$$

n : indice d'échantillon
m : exposant de codage
en puissance de 2

INIT        BUF

$M(n)=0$   pour $\forall n$

$V_1 \longrightarrow$ BUF

$M(n)$:indice temps
de l'échantillon $\underline{n}$

NON   $\left| \dfrac{V_n + V_{(n+2^m)}}{2} - V_{(n+2^{m-1})} \right| \leqslant k$   OUI

$V_{(n+2^{m-1})} \longrightarrow$ BUF

$M(n+2^{m-1})$ inchangé

$V_{(n+2^{m-1})} \longrightarrow$ BUF

$V_{(n+2^m)} \longrightarrow$ BUF

$M(n+2^m)=M(n+2^m)+1$

$n+1 \longrightarrow n$

NON   $M(n+2^m) = M(n)$   OUI

$n+2^m \longrightarrow n$

$n-2^m \longrightarrow n$

$m=1$

$m+1 \longrightarrow m$

NON   BUF PLEIN ?   OUI

ECRITURE BUL

1

FIG. 1

FIG. 2

2 octets